# EUROPEAN PATENT APPLICATION

(11) **EP 4 618 422 A1**
(43) Date of publication of application: **17.09.2025**
(21) Application number: 22968186.1
(22) Date of filing: 15.12.2022
(51) Int. Cl.: H03M 1/12

(54) **ANALOG FRONT-END CIRCUIT AND WORKING METHOD THEREFOR, AND GENE SEQUENCING CHIP**

(71) Applicant: BGI Shenzhen, Shenzhen, Guangdong 518083 (CN); BGI Shenzhen Co., Limited, Guangdong 518083 (CN)
(72) Inventor: KONG, Liuer, Shenzhen, Guangdong 518083 (CN); SONG, Ziqi, Shenzhen, Guangdong 518083 (CN); YUN, Quanxin, Shenzhen, Guangdong 518083 (CN); LI, Yuxiang, Shenzhen, Guangdong 518083 (CN); DONG, Yuliang, Shenzhen, Guangdong 518083 (CN); ZHANG, Wenwei, Shenzhen, Guangdong 518083 (CN); XU, Xun, Shenzhen, Guangdong 518083 (CN)
(74) Representative: HGF
(86) International application number: PCT/CN2022/139265
(87) International publication number: WO 2024/124478

(57) **Abstract**

An analog front-end circuit, a working method thereof, and a gene sequencing chip are provided. The analog front-end circuit includes a pre-amplifier, a multiplexing capacitor, a state switching unit, and a post-amplifier. The state switching unit is configured to, in a first state, connect a first terminal of the multiplexing capacitor to a first input terminal of the pre-amplifier and connect a second terminal of the multiplexing capacitor to an output terminal of the pre-amplifier, and configured to, in a second state, connect the first terminal of the multiplexing capacitor to a first level and connect a second terminal of the multiplexing capacitor to a first input terminal of the post-amplifier.

## Description

### TECHNICAL FIELD

This application relates to the field of test and measurement technologies, for example, to an analog front-end circuit, a working method thereof, and a gene sequencing chip.

### BACKGROUND

An analog front-end circuit can amplify a to-be-measured signal to obtain an amplified signal used for analysis and computation. Analog front-end circuits have important applications in modem testing and measurement fields.

However, in the related art, the analog front-end circuit typically includes multi-stage amplifiers and multiple capacitors, resulting in the analog front-end circuit being larger in size and more difficult to miniaturize.

### SUMMARY

This application provides an analog front-end circuit, a working method thereof, and a gene sequencing chip, reducing the size of the analog front-end circuit and facilitating miniaturization of the analog front-end circuit.

According to an aspect of this application, an analog front-end circuit is provided. The analog front-end circuit includes a pre-amplifier, a multiplexing capacitor, a state switching unit, and a post-amplifier.

The state switching unit is configured to: in a first state, connect the first terminal of the multiplexing capacitor to the first input terminal of the pre-amplifier and connect the second terminal of the multiplexing capacitor to the output terminal of the pre-amplifier, and configured to, in a second state, connect the first terminal of the multiplexing capacitor to a first level and connect the second terminal of the multiplexing capacitor to the first input terminal of the post-amplifier.

According to another aspect of this application, a gene sequencing chip is provided.

Multiple analog front-end circuits are integrated in the gene sequencing chip. Each of the analog front-end circuits is the preceding analog front-end circuit.

The first input terminal of the pre-amplifier is configured to receive a gene modulation current signal.

According to another aspect of this application, a working method of an analog front-end circuit is provided. The analog front-end circuit is the preceding analog front-end circuit. The analog front-end circuit includes N integration periods in each working period, where N ≥ 1.

Each integration period includes an amplification phase and a multiplexing phase, and the working method includes: controlling the state switching unit to switch to the first state in the amplification phase; and controlling the state switching unit to switch to the second state in the multiplexing phase.

### BRIEF DESCRIPTION OF DRAWINGS

FIG. 1 is a circuit diagram of an analog front-end circuit according to an embodiment of this application.
FIG. 2 is a circuit diagram of the analog front-end circuit of FIG. 1 in a first working state.
FIG. 3 is a circuit diagram of the analog front-end circuit of FIG. 1 in a second working state.
FIG. 4 is a circuit diagram of another analog front-end circuit according to an embodiment of this application.
FIG. 5 is a circuit diagram of the analog front-end circuit of FIG. 4 in a first working state.
FIG. 6 is a circuit diagram of the analog front-end circuit of FIG. 4 in a second working state.
FIG. 7 is a timing diagram of an analog front-end circuit according to an embodiment of this application.
FIG. 8 is a diagram illustrating the structure of a gene sequencing chip according to an embodiment of this application.
FIG. 9 is a diagram illustrating the structure of a detection unit according to an embodiment of this application.
FIG. 10 is a flowchart of a working method of an analog front-end circuit according to an embodiment of this application.

### DETAILED DESCRIPTION

It is to be noted that terms such as "first" and "second" in the description, claims, and drawings of this application are used for distinguishing between similar objects and are not necessarily used for describing a particular order or sequence. It is to be understood that data used in this manner are interchangeable where appropriate so that the embodiments of this application described herein can be implemented in an order not illustrated or described herein. Additionally, the terms "including", "having" and any other variations thereof are intended to encompass a non-exclusive inclusion. For example, a process, method, system, product, or device that includes a series of steps or units not only includes the expressly listed steps or units but may also include other steps or units that are not expressly listed or are inherent to such process, method, product, or device.

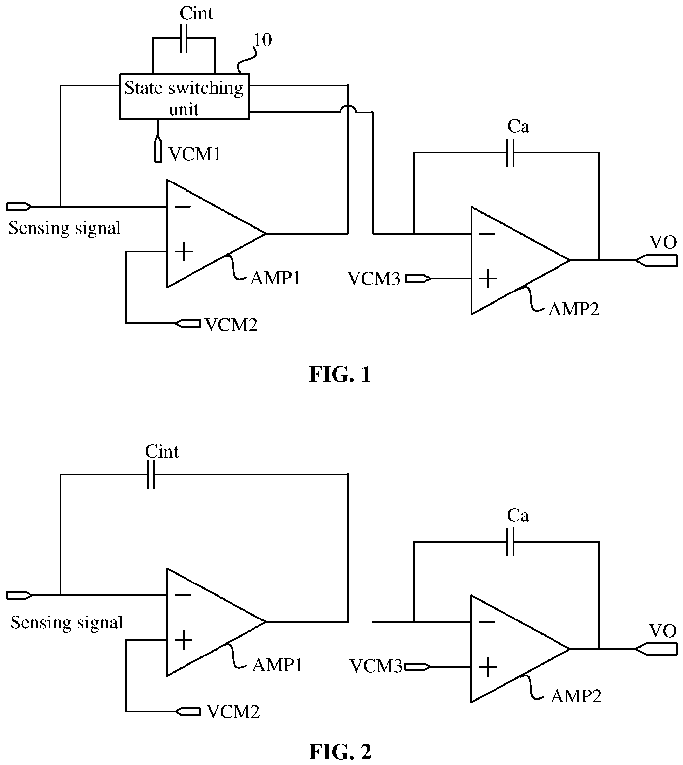

FIG. 1 is a circuit diagram of an analog front-end circuit according to an embodiment of this application. Referring to FIG. 1, the analog front-end circuit includes a pre-amplifier (AMP1), a multiplexing capacitor (Cint), a state switching unit 10, and a post-amplifier (AMP2). The state switching unit 10 is configured to, in a first state, connect the first terminal of the multiplexing capacitor (Cint) to the first input terminal of the pre-amplifier (AMP1) and connect the second terminal of the multiplexing capacitor (Cint) to the output terminal of the pre-amplifier (AMP1); and configured to, in a second state, connect the first terminal of the multiplexing capacitor (Cint) to a first level (VCM1) and connect the second terminal of the multiplexing capacitor (Cint) to the first input terminal of the post-amplifier (AMP2).

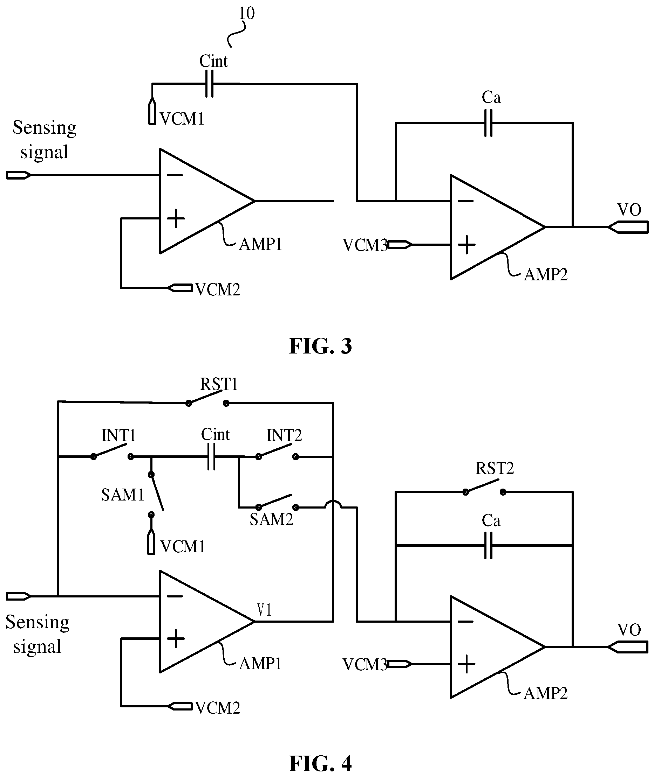

For example, the analog front-end circuit may amplify a sensing signal (Sensor) input to its input terminal so that the amplified signal can be used for information processing. In this embodiment, the analog front-end circuit may be applied to the field of gene sequencing, and the sensing signal (Sensor) may be a gene modulation current signal. The gene modulation current signal is a weak electrical signal generated through converting nucleotide molecule type information by a biosensor. The value of the current signal represents the type information of the biological nucleotide molecule. The pre-amplifier (AMP1) is configured to perform primary amplification on the sensing signal Sensor to generate a first characteristic modulation voltage signal. The post-amplifier (AMP2) is configured to amplify the first characteristic modulation voltage signal to generate a second characteristic modulation voltage signal. In this embodiment, the state switching circuit includes two working states, as shown in FIG. 2 and FIG. 3. FIG. 2 is a circuit diagram of the analog front-end circuit of FIG. 1 in a first working state. FIG. 3 is a circuit diagram of the analog front-end circuit of FIG. 1 in a second working state. In the first working state, two terminals of the multiplexing capacitor (Cint) are connected to the first input terminal and the output terminal of the pre-amplifier (AMP1) respectively, and the multiplexing capacitor (Cint) stores the first characteristic modulation voltage signal. Then, the state switching circuit is switched to the second state, one terminal of the multiplexing capacitor (Cint) is connected to the first level (VCM1), and the other terminal of the multiplexing capacitor (Cint) is connected to the first input terminal of the post-amplifier (AMP2). Since the voltage across the two terminals of the capacitor cannot change abruptly, the first characteristic modulation voltage signal stored on the multiplexing capacitor (Cint) is coupled to the first input terminal of the post-amplifier (AMP2) and is amplified by the post-amplifier (AMP2) into the second characteristic modulation voltage signal (VO). That is, by setting the working states of the state switching unit, a coupling capacitor between the pre-amplifier and the post-amplifier can be eliminated, and the multiplexing capacitor can be directly multiplexed as the coupling capacitor. Since the area occupied by a capacitor in the integrated circuit is large, the analog front-end circuit of this embodiment can be provided with one less capacitor, and thus the size of the analog front-end circuit can be greatly reduced in this embodiment.

In this embodiment, the analog front-end circuit includes a pre-amplifier, a multiplexing capacitor, a state switching unit, and a post-amplifier. The state switching unit is configured to, in the first state, connect the first terminal of the multiplexing capacitor to the first input terminal of the pre-amplifier and connect the second terminal of the multiplexing capacitor to the output terminal of the pre-amplifier or configured to, in the second state, connect the first terminal of the multiplexing capacitor to the first level and connect the second terminal of the multiplexing capacitor to the first input terminal of the post-amplifier. By setting the working states of the state switching unit, the coupling capacitor between the pre-amplifier and the post-amplifier can be eliminated, and the multiplexing capacitor can be directly multiplexed as the coupling capacitor. Since the area occupied by a capacitor in the integrated circuit is large, the analog front-end circuit of this embodiment can be provided with one less capacitor, and thus the size of the analog front-end circuit can be greatly reduced in this embodiment. In addition, the area saved by reducing the number of capacitors can also supplement the area for arranging the operational transconductance amplifier (OTA), thereby optimizing and improving the circuit performance, and improving the power supply wiring strength.

For example, FIG. 4 is a circuit diagram of another analog front-end circuit according to an embodiment of this application. Referring to FIG. 4, the state switching unit includes a first switch (INT1), a second switch (SAM1), a third switch (INT2), and a fourth switch (SAM2). The first terminal of the first switch (INT1) is electrically connected to the first terminal of the pre-amplifier (AMP1). The second terminal of the first switch (INT1) is electrically connected to the first terminal of the multiplexing capacitor (Cint). The first terminal of the second switch (SAM1) is connected to a first level (VCM1). The second terminal of the second switch (SAM2) is electrically connected to the first terminal of the multiplexing capacitor (Cint). The first terminal of the third switch (INT2) is electrically connected to the second terminal of the multiplexing capacitor (Cint). The second terminal of the third switch (INT2) is electrically connected to the output terminal of the pre-amplifier (AMP1). The first terminal of the fourth switch (SAM2) is electrically connected to the second terminal of the multiplexing capacitor (Cint). The second terminal of the fourth switch (SAM2) is electrically connected to the first input terminal of the post-amplifier (AMP2).

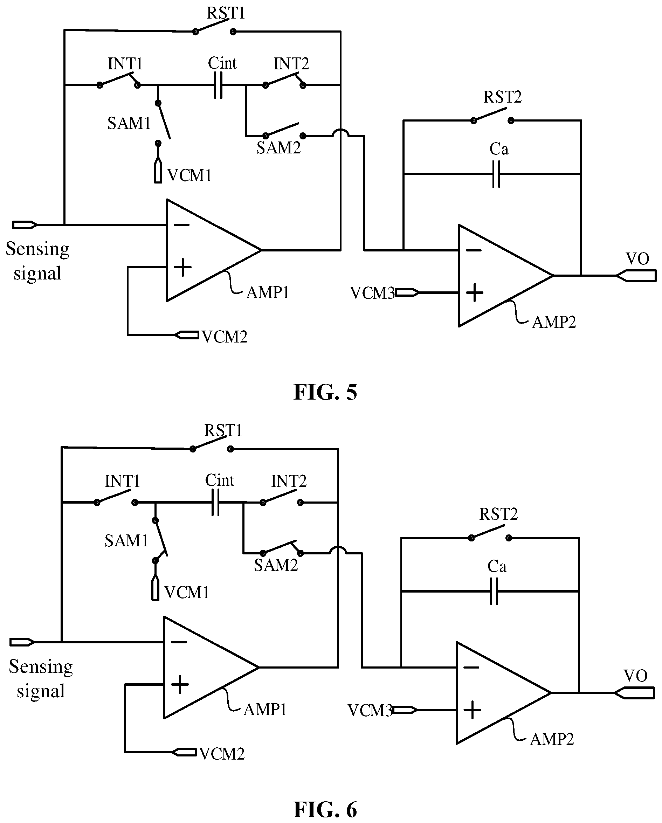

For example, the state switching unit in this embodiment may be composed of four switches. The state of the state switching unit is switched through the state switching of the switches. FIG. 5 is a circuit diagram of the analog front-end circuit of FIG. 4 in a first working state. FIG. 6 is a circuit diagram of the analog front-end circuit of FIG. 4 in a second working state. Referring to FIG. 4 to FIG. 6, in the first state, the first switch (INT1) and the third switch (INT2) are turned on, and the second switch (SAM1) and the fourth switch (SAM2) are turned off, so that two terminals of the multiplexing capacitor (Cint) are connected between the first input terminal and the output terminal of the pre-amplifier (AMP1); and in the second state, the first switch (INT1) and the third switch (INT2) are turned off, and the second switch (SAM1) and the fourth switch (SAM2) are turned on, so that one terminal of the multiplexing capacitor (Cint) is connected to the first level (VCM1), and the other terminal of the multiplexing capacitor (Cint) is connected to the first input terminal of the post-amplifier (AMP2), so that the signal stored on the multiplexing capacitor (Cint) is coupled to the first input terminal of the post-amplifier (AMP2).

For example, the analog front-end circuit may also include a controller for precisely controlling the working states of the first switch (INT1), the second switch (SAM1), the third switch (INT2), and the fourth switch (SAM2). At least one of the first switch (INT1), the second switch (SAM1), the third switch (INT2), or the fourth switch (SAM2) is a complementary field effect transistor. For example, each of the four switches is a complementary field effect transistor. Control terminals of the switches are all connected to the controller. The controller sends a control signal to control the states of the switches. The switches may be turned on in response to a low level and turned off in response to a high level or may be turned on in response to a high level and turned off in response to a low level. Certainly, when the analog front-end circuits are integrated into a chip, the chip may include multiple detection units. Each detection unit includes an analog front-end circuit. In this case, one controller may be set on the chip, with the analog front-end circuits on the chip multiplexing the controller.

For example, with continued reference to FIG. 4, the analog front-end circuit also includes a feedback capacitor (Ca), a first reset switch (RST1), and a second reset switch (RST2). The first terminal of the feedback capacitor (Ca) is electrically connected to the first input terminal of the post-amplifier (AMP2). The second terminal of the feedback capacitor (Ca) is electrically connected to the output terminal of the post-amplifier (AMP2). The first terminal of the first reset switch (RST1) is electrically connected to the first input terminal of the pre-amplifier (AMP1). The second terminal of the first reset switch (RST1) is electrically connected to the output terminal of the pre-amplifier (AMP1). The first terminal of the second reset switch (RST2) is electrically connected to the first input terminal of the post-amplifier (AMP2). The second terminal of the second reset switch (RST2) is electrically connected to the output terminal of the post-amplifier (AMP2). In this embodiment, the multiplexing capacitor (Cint) and the feedback capacitor (Ca) may each be plate capacitors of a metal-metal structure.

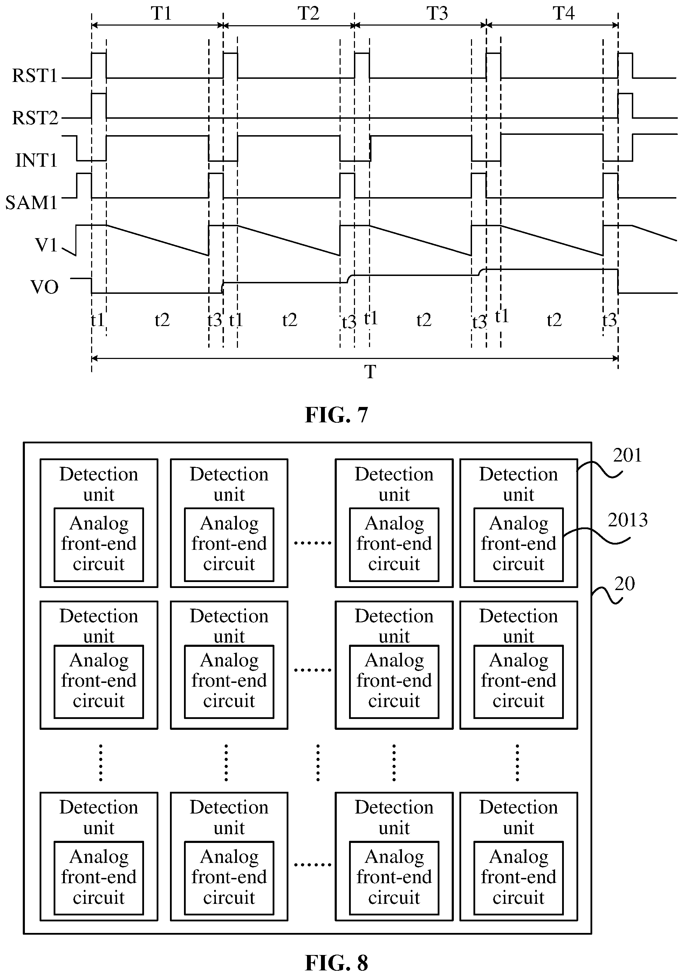

For example, the first reset switch (RST1) may be configured to reset the pre-amplifier, and the second reset switch may be configured to reset the post-amplifier (AMP2). In a working period of the analog front-end circuit, the pre-amplifier (AMP1) usually needs to perform signal sampling multiple times. The sampled signals are accumulated in the post-amplifier. The final signal output by the post-amplifier is used as a final sampled signal. FIG. 7 is a timing diagram of an analog front-end circuit according to an embodiment of this application. FIG. 7 corresponds to FIG. 4. Referring to FIG. 7 and FIG. 4, in this embodiment, an example in which all switches are turned on at a high level and turned off at a low level is used for description.

For example, the analog front-end circuit integrates four times in each working period T. That is, the analog front-end circuit includes a first integration period T1, a second integration period T2, a third integration period T3, and a fourth integration period T4. Each integration period includes a reset phase t1, an amplification phase t2, and a multiplexing phase t3. In the reset phase t1 corresponding to the first integration period in each working period T, the second reset switch (RST2) is used to reset the post-amplifier (AMP2).

In the reset phase t1, the first reset switch (RST1) is turned on by receiving a high level signal, the first switch (INT1) and the second switch (SAM1) are turned off by receiving a low level signal, and the pre-amplifier (AMP1) is reset. It is to be noted that the third switch (INT2) and the first reset switch (RST1) have the same timing, and the fourth switch (SAM2) and the second switch (SAM1) have the same timing.

In the amplification phase t2, both the first reset switch (RST1) and the second reset switch (RST2) are turned off in response to a low level; the first switch (INT1) and the third switch (INT2) are turned on in response to a high level, and the second switch (SAM1) and the fourth switch (SAM2) are turned off in response to a low level. At this time, the two terminals of the multiplexing capacitor (Cint) are connected between the first input terminal and the output terminal of the pre-amplifier (AMP1), the pre-amplifier (AMP1) is in an integral amplification state, and the first characteristic modulation voltage signal (V1) output by the pre-amplifier (AMP1) is stored on the multiplexing capacitor (Cint).

In the multiplexing phase t3, the first reset switch (RST1) and the second reset switch (RST2) are both turned off in response to a low level; the first switch (INT1) and the third switch (INT2) are turned off in response to a low level, and the second switch (SAM1) and the fourth switch (SAM2) are turned on in response to a high level. At this time, the two terminals of the multiplexing capacitor (Cint) are connected to the first level (VCM1) and the first input terminal of the post-amplifier (AMP2) respectively, and the first characteristic modulation voltage signal stored on the multiplexing capacitor (Cint) is coupled to the post-amplifier, amplified by the post-amplifier, and then output.

Then, in the next integration period, the reset stage t1, the amplification stage t2, and the multiplexing stage t3 are still included. In the reset stage t1, the second reset switch (RST2) remains in the off state, that is, at this time, the post-amplifier (AMP2) does not reset, but undergoes data accumulation. After multiple data accumulations, the sensing signal (Sensor) is amplified from a small signal to a large signal that can be processed.

For example, with continued reference to FIG. 4, the second input terminal of the pre-amplifier (AMP1) is connected to the second level (VCM2), and the second input terminal of the post-amplifier (AMP2) is connected to the third level (VCM3).

For example, the first input terminal of the pre-amplifier (AMP1) may be an inverting input terminal, and the second input terminal of the pre-amplifier (AMP1) may be a non-inverting input terminal; and the first input terminal of the post-amplifier (AMP2) may be an inverting input terminal, and the second input terminal of the post-amplifier (AMP2) may be a non-inverting input terminal. The second level (VCM2) is a direct current level and is used for setting a static operating point of the pre-amplifier so that the pre-amplifier (AMP1) operates in an optimal working state. The third level (VCM3) is a direct current level and is used for setting a static operating point of the post-amplifier so that the post-amplifier (AMP2) operates in an optimal working state. For example, the first level is multiplexed as the second level and the third level. In this case, the analog front-end circuit requires fewer direct current signals, and therefore requires fewer signal lines, better reducing the size of the analog front-end circuit.

An embodiment of this application provides a gene sequencing chip. FIG. 8 is a diagram illustrating the structure of a gene sequencing chip according to an embodiment of this application. The gene sequencing chip 20 may be integrated with multiple detection units 201. Each detection unit 201 includes the analog front-end circuit 2013 of this embodiment of this application. The input terminal (the first input terminal of the pre-amplifier) of the analog front-end circuit 2013 is configured to receive a gene modulation current signal. Because the gene sequencing chip of this embodiment of this application includes the analog front-end circuit of this embodiment of this application, the gene sequencing chip has the same beneficial effect. The details are not described here again.

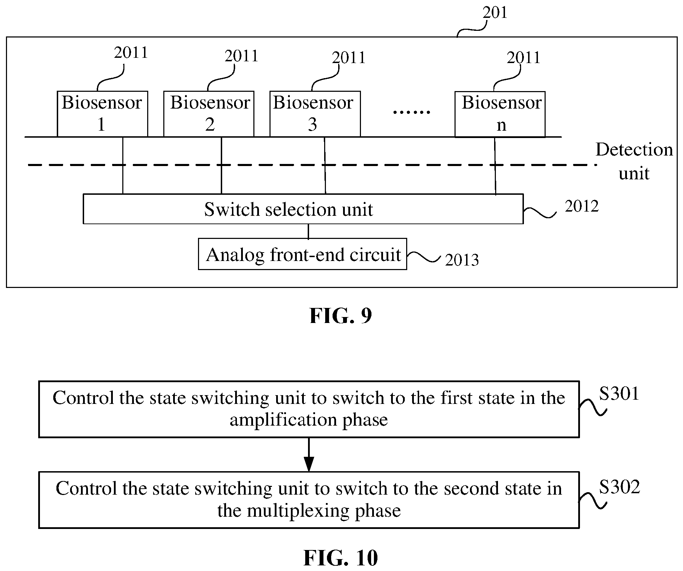

FIG. 9 is a diagram illustrating the structure of a detection unit according to an embodiment of this application. Each detection unit 201 includes a biosensor 2011, a switch selection module 2012, and an analog front-end circuit 2013. The biosensor 2011 is configured to convert biological nucleotide molecular type information into a gene modulation current signal. The switch selection module 2012 is configured to select the gene modulation current signal. The analog front-end circuit 2013 is configured to amplify the selected gene modulation current signal so that the amplified signal can be used for information processing. There may be N biosensors, where N ≥ 1.

An embodiment of this application provides a working method of an analog front-end circuit. As shown in FIG. 10, a flowchart of a working method of an analog front-end circuit according to an embodiment of this application, the analog front-end circuit includes N integration periods in each working period, where N ≥ 1, and each integration period includes an amplification phase and a multiplexing phase. The working method includes: in step S301, controlling the state switching unit to switch to the first state in the amplification phase; and in step S302, controlling the state switching unit to switch to the second state in the multiplexing phase.

For example, when the state switching unit is in the first working state, the two terminals of the multiplexing capacitor are connected to the first input terminal and the output terminal of the pre-amplifier respectively, and the multiplexing capacitor stores the first characteristic modulation voltage signal. Then the state switching circuit is switched to the second state. At this time, one terminal of the multiplexing capacitor is connected to the first level, and the other terminal of the multiplexing capacitor is connected to the first input terminal of the post-amplifier. Since the voltage across the two terminals of the multiplexing capacitor cannot change abruptly, the first characteristic modulation voltage signal stored on the multiplexing capacitor is coupled to the first input terminal of the post-amplifier and is amplified by the post-amplifier into the second characteristic modulation voltage signal. Therefore, according to the working method of the analog front-end circuit of this embodiment, the amplification function of the analog front-end circuit can be implemented by using fewer capacitors so that the size of the analog front-end circuit can be greatly reduced in this embodiment.

For example, in each integration period, a reset stage is also included before each amplification stage. The first reset switch is turned on in the reset phase; the second reset switch is turned on in the reset phase in the first integration period in each working period. In a working period of the analog front-end circuit, the pre-amplifier usually needs to perform signal sampling multiple times. The sampled signals are accumulated in the post-amplifier. The final signal output by the post-amplifier is used as the sampled signal. Therefore, the post-amplifier is reset first at the beginning of each working period, and the pre-amplifier is reset in each integration period. In each working period, multiple first characteristic modulation voltage signals are accumulated in the post-amplifier and are amplified by the post-amplifier to form a large signal that can be directly processed.

It is to be understood that various forms of the preceding flows may be used with steps reordered, added, or removed. For example, the steps described in this application may be executed in parallel, in sequence, or in a different order as long as the desired results of the technical solutions in this application can be achieved. The execution sequence of these steps is not limited herein.

## Claims

1. An analog front-end circuit, comprising a pre-amplifier, a multiplexing capacitor, a state switching unit, and a post-amplifier;
wherein the state switching unit is configured to:
in a first state, connect a first terminal of the multiplexing capacitor to a first input terminal of the pre-amplifier and connect a second terminal of the multiplexing capacitor to an output terminal of the pre-amplifier; and
in a second state, connect the first terminal of the multiplexing capacitor to a first level and connect the second terminal of the multiplexing capacitor to a first input terminal of the post-amplifier.

2. The analog front-end circuit of claim 1, wherein the state switching unit comprises a first switch, a second switch, a third switch, and a fourth switch;
wherein a first terminal of the first switch is electrically connected to a first terminal of the pre-amplifier, and a second terminal of the first switch is electrically connected to the first terminal of the multiplexing capacitor;
a first terminal of the second switch is connected to the first level, and a second terminal of the second switch is electrically connected to the first terminal of the multiplexing capacitor;
a first terminal of the third switch is electrically connected to the second terminal of the multiplexing capacitor, and a second terminal of the third switch is electrically connected to the output terminal of the pre-amplifier; and
a first terminal of the fourth switch is electrically connected to the second terminal of the multiplexing capacitor, and a second terminal of the fourth switch is electrically connected to the first input terminal of the post-amplifier.

3. The analog front-end circuit of claim 2, further comprising a controller configured to control a state of the first switch, a state of the second switch, a state of the third switch, and a state of the fourth switch.

4. The analog front-end circuit of claim 2, wherein at least one of the first switch, the second switch, the third switch, or the fourth switch is a complementary field effect transistor.

5. The analog front-end circuit of claim 1, further comprising a feedback capacitor, a first reset switch, and a second reset switch;
wherein a first terminal of the feedback capacitor is electrically connected to the first input terminal of the post-amplifier, and a second terminal of the second reset switch is electrically connected to an output terminal of the post-amplifier;
a first terminal of the first reset switch is electrically connected to the first input terminal of the pre-amplifier, and a second terminal of the first reset switch is electrically connected to the output terminal of the pre-amplifier; and
a first terminal of the second reset switch is electrically connected to the first input terminal of the post-amplifier, and a second terminal of the second reset switch is electrically connected to the output terminal of the post-amplifier.

6. The analog front-end circuit of claim 1, wherein a second input terminal of the pre-amplifier is connected to a second level, and a second input terminal of the post-amplifier is connected to a third level.

7. The analog front-end circuit of claim 6, wherein the first level is multiplexed as the second level and the third level.

8. A gene sequencing chip, wherein a plurality of detection units are integrated in the gene sequencing chip, each of the plurality of detection units comprises the analog front-end circuit of any one of claims 1 to 7; and
an input terminal of the analog front-end circuit is configured to receive a gene modulation current signal.

9. The gene sequencing chip of claim 8, wherein each of the plurality of detection units further comprises a biosensor and a switch selection module;
wherein the biosensor is configured to convert biological nucleotide molecular type information into the gene modulation current signal;
the switch selection module is configured to select the gene modulation current signal; and
the analog front-end circuit is configured to amplify the selected gene modulation current signal.

10. A working method of an analog front-end circuit, wherein the analog front-end circuit is the analog front-end circuit of any one of claims 1 to 7, the analog front-end circuit comprises N integration periods in each of a plurality of working periods, and N ≥ 1; and
each of the N integration periods comprises an amplification phase and a multiplexing phase; wherein the method comprises:
controlling the state switching unit to switch to the first state in the amplification phase; and
controlling the state switching unit to switch to the second state in the multiplexing phase.

11. The method of claim 10, wherein the analog front-end circuit further comprises a first reset switch and a second reset switch;
wherein a first terminal of the first reset switch is electrically connected to the first input terminal of the pre-amplifier, and a second terminal of the first reset switch is electrically connected to the output terminal of the pre-amplifier;
a first terminal of the second reset switch is electrically connected to the first input terminal of the post-amplifier, and a second terminal of the post-amplifier is electrically connected to an output terminal of the post-amplifier; and
each of the N integration periods further comprises a reset phase before the amplification phase; and
the method further comprises:
turning on the first reset switch in the reset phase; and
turning on the second reset switch in the reset phase in a first integration period in each of the plurality of working periods.
